# EUROPÄISCHE PATENTSCHRIFT

(11) **EP 2 407 015 B1**
(45) Veröffentlichungstag und Bekanntmachung des Hinweises auf die Patenterteilung: **26.12.2012**
(21) Anmeldenummer: 09776457.5
(22) Anmeldetag: 13.03.2009
(51) Int. Cl.: H05K 7/14, H01L 23/00, H01L 23/10, H01L 25/07, H05K 7/20

(54) **LEISTUNGSHALBLEITERMODUL MIT SCHICHTWEISE AUFGEBAUTEN ISOLIERENDEN SEITENWÄNDEN**
POWER SEMICONDUCTOR MODULE HAVING LAYERED INSULATING SIDE WALLS
MODULE À SEMI-CONDUCTEURS DE PUISSANCE POURVU DE PAROIS LATÉRALES ISOLANTES À STRUCTURE EN COUCHES

(43) Veröffentlichungstag der Anmeldung: 18.01.2012
(73) Patentinhaber: Siemens Aktiengesellschaft, 80333 München (DE)
(72) Erfinder: BILLMANN, Markus, 91448 Emskirchen (DE); BLÖSCH, Christoph, 91088 Bubenreuth (DE); MALIPAARD, Dirk, 90461 Nürnberg (DE); ZENKNER, Andreas, 90587 Obermichelbach (DE)
(86) Internationale Anmeldenummer: PCT/EP2009/002056
(87) Internationale Veröffentlichungsnummer: WO 2010/102654

(56) Entgegenhaltungen:
- EP-A2- 1 662 568
- WO-A1-2008/031372
- DE-A1- 19 839 422
- DATABASE WPI Week 198632 Thomson Scientific, London, GB; AN 1986-211048 XP002554478 -& SU 1 202 088 A1 (NAGORNY MIKHAIL A) 30. Dezember 1985 (1985-12-30)

## Beschreibung

Die Erfindung betrifft ein Leistungshalbleitermodul mit wenigstens zwei miteinander verschalteten Leistungshalbleitereinheiten, die ansteuerbare Leistungshalbleiter aufweisen, einem Modulgehäuse, in dem die Leistungshalbleitereinheiten angeordnet sind und das eine elektrisch isolierende Seitenwandung aufweist, und wenigstens einer Anschlussschiene, die sich durch die Seitenwandung hindurch erstreckt und mit wenigsten einer der Leistungshalbleitereinheiten verbunden ist.

Ein solches Leistungshalbleitermodul ist beispielsweise aus der WO 2008/031372 bereits bekannt. Das dort offenbarte Leistungshalbleitermodul weist zwei miteinander verschaltete Leistungshalbleitereinheiten auf. Jede Leistungshalbleitereinheit verfügt über eine Vielzahl von Leistungshalbleiterchips, wie beispielsweise IGBTs, GTOs oder dergleichen, die miteinander verbunden und in einem eigenen Einheitengehäuse angeordnet sind. Jede Leistungshalbleitereinheit bildet eine Anode und eine Katode sowie einen Steueranschluss aus. Mit Hilfe von geeigneten Steuersignalen an den Steueranschluss kann der Stromfluss zwischen Anode und Katode unterbrochen oder zugelassen werden. Von den besagten Leistungshalbleitereinheiten sind wenigstens zwei in einem gesonderten Modulgehäuse angeordnet, das zum Explosionsschutz dient. Mittels einer zweckmäßigen Verschienung, welche die Wandungen des Modulgehäuses durchgreift, ist der Strompfad von den Leistungshalbleitereinheiten nach außen geführt.

Aus der DE 198 39 422 A1 ist eine Leistungshalbleitereinheit bekannt, die ansteuerbare Leistungshalbleiter aufweist. Die

Leistungshalbleitereinheit weist ein Gehäuse auf, in dem die Leistungshalbleiter in Gestalt von Leistungshalbleiterchips angeordnet sind. Zum Schutz vor Fragmenten, die bei einer Explosion der Leistungshalbleitereinheit weggeschleudert werden könnten, dient ein netzartiges Explosionsschutzelement.

Auch die EP 1 662 568 A2 offenbart eine Leistungshalbleitereinheit mit ansteuerbaren Leistungshalbleiterchips.

Die SU 1 202 088 A1 offenbart ein Gehäuse, das als Stapel isolierender Teilelemente ausgebildet ist.

Aufgabe der Erfindung ist es, ein Leistungshalbleitermodul der eingangs genannten Art bereitzustellen, das eine hohe Explosionsfestigkeit aufweist und in seiner Herstellung besonders kostengünstig ist.

Die Erfindung löst diese Aufgabe dadurch, dass die isolierende Seitenwandung als Stapel isolierender und einstückig ausgebildeter Teilelemente ausgebildet ist, wobei die Teilelemente mit Kontaktbereichen aneinander anliegen.

Erfindungsgemäß sind Leistungshalbleitereinheiten, die zumindest ansteuerbare Leistungshalbleiter, wie beispielsweise IGBTs, GTOs, Thyristoren oder dergleichen aufweisen, in einem explosionsfesten Modulgehäuse angeordnet. Dabei weisen die ansteuerbaren Leistungshalbleitereinheiten neben einem Anoden- und einem Katodenanschluss auch einen Steueranschluss auf, um den Stromfluss über Anode und Katode des steuerbaren Leistungshalbleiters zu schalten. Um den Strompfad über die Leistungshalbleitereinheiten aus dem Modulgehäuse herauszuführen, ist wenigstens eine Anschlussschiene vorgesehen, welche die isolierende Seitenwandung des Modulgehäuses durchgreift.

Im Bereich der Energieverteilung, beispielsweise der Hochspannungsgleichstromübertragung (HGÜ) oder der so genannten "Flexible AC Transmission Systems (FACTS)", ist es üblich, hohe Wechselspannungen in Gleichspannungen umzuformen oder umgekehrt. Hierzu werden zwar in der Regel eine Vielzahl von erfindungsgemäßen Leistungshalbleitermodulen in Reihe geschaltet. Trotz der Reihenschaltung fällt jedoch an jedem einzelnen der Leistungshalbleitermodule eine hohe Spannung ab. Diese hohe Spannung kann insbesondere im Fehlerfall zur explosionsartigen Zerstörungen der Leistungshalbleitereinheiten führen. Das Modulgehäuse dient Sicherheitszwecken, so dass die im Explosionsfall auftretenden Explosionsgase von dem Modulgehäuse sicher aufgenommen beziehungsweise abgeführt werden können. Schädigungen anderer Leistungshalbleitermodule können auf diese Weise vermieden werden.

Um eine kostengünstige Herstellung solcher Leistungshalbleitermodule zu gewährleisten, wird erfindungsgemäß vorgeschlagen, die isolierende Seitenwandung des Leistungshalbleitermoduls, durch die sich in der Regel mehrere Anschlussschienen zur Kontaktierung der im Inneren des Modulgehäuses liegenden Leistungshalbleitereinheiten erstrecken, aus mehreren aufeinander gestapelten Teilelementen auszubilden. Die Teilelemente selbst bestehen aus einem elektrisch isolierenden Material. Bei Betrieb des erfindungsgemäßen Leistungshalbleitermoduls liegen die gestapelten Teilelemente aneinander an, so dass zwischen ihnen Anstoßfugen definiert sind, die ein Herausführen der Anschlussschiene(n) aus dem Modulgehäuse beträchtlich erleichtern.

Erfindungsgemäß kann beispielsweise zunächst ein Teilelement, anschließend eine Anschlussschiene, dann ein weiteres Teilelement, dann eine weitere Anschlussschiene, die von der besagten ersten Verschienung isoliert montiert werden muss, und schließlich ein weiteres Teilelement aufeinander gestapelt werden. Die Anschlussschiene ist mit den gewünschten Leistungshalbleitereinheiten verbunden. Bei Betrieb des Leistungshalbleitermoduls führt der auf einem Hochspannungspotenzial liegende Strompfad also über eine Anschlussschiene in das Modulgehäuse, über die dort angeordneten Leistungshalbleitereinheiten und von dort wieder über eine weitere Anschlussschiene aus dem Modulgehäuse heraus.

Gemäß einer bevorzugten Ausgestaltung der Erfindung sind die Teilelemente umfänglich geschlossen ausgebildet. Auf diese Weise ist eine noch höhere Explosionsfestigkeit bereitgestellt, wobei die Herstellungskosten weiterhin gering bleiben. Die Teilelemente können als geschlossene oder ringförmige Teilelemente unabhängig vom restlichen Modulgehäuse hergestellt werden. Aufwändige Fügeverfahren bei der Montage der Seitenwandung sind auf diese Weise vermieden.

Vorteilhafterweise weisen die Teilelemente wenigstens eine Verstärkungsrippe auf. Die Verstärkungsrippe erstreckt sich beispielsweise bei einem ringförmigen umfänglich geschlossenen Teilelement zwischen zwei sich gegenüber liegenden Begrenzungswänden. Zweckmäßigerweise begrenzen die Teilsegmente und gegebenenfalls die Verstärkungsrippe(n) Hohlräume oder Teile eines Hohlraums, in dem im zusammengebauten Zustand des Leistungshalbleitermoduls die Leistungshalbleitereinheiten angeordnet sind.

Vorteilhafterweise durchragt wenigstens eine der Anschlussschienen die Seitenwandung zwischen zwei Teilelementen. Mit anderen Worten erstreckt sich jede Anschlussschiene durch eine Anstoßfuge.

Gemäß einer diesbezüglich zweckmäßigen Weiterentwicklung weist eines der Teilelemente in seinem Kontaktbereich eine Aussparung auf, durch die hindurch sich die Anschlussverschienung erstreckt. Mit Hilfe dieser Aussparung ist die Montage des Leistungshalbleitermoduls noch weiter erleichtert. So kann zunächst das die Aussparung aufweisende Teilelement mit dem Rest des Leistungshalbleitermoduls verbunden und anschließend die Verschienung montiert werden.

Zweckmäßigerweise sind die Aussparungen und die sich durch diese hindurch erstreckende Anschlussschiene formkomplementär zueinander ausgebildet. Durch die formkomplementäre Ausbildung ist das Austreten von Explosionsgasen im Fehlerfall im Wesentlichen verhindert. Die Seitenwand umschließt jede Anschlussschiene dichtend. Auf diese Art und Weise kann ein Explosionsschaden weiter minimiert werden.

Vorteilhafterweise bestehen die Teilelemente aus einem faserverstärkten Kunststoff. Durch die Faserverstärkung ist der Kunststoff besonders explosionsfest. Faserverstärkte Kunststoffe sind bestens bekannt, so dass auf deren chemische Zusammensetzung hier nicht genauer eingegangen zu werden braucht. Insbesondere kommen glasfaserverstärkter Kunststoffe in Betracht.

Vorteilhafterweise weist jede Leistungshalbleitereinheit Leistungshalbleiterchips und ein Einheitengehäuse auf, in dem die Leistungshalbleiterchips angeordnet sind. Solche Leistungshalbleitereinheiten sind am Markt erhältlich und können besonders kostengünstig bezogen werden. Die Kosten des erfindungsgemäßen Leistungshalbleitermoduls sind somit noch weiter reduziert.

Gemäß einer diesbezüglich zweckmäßigen Weiterentwicklung sind die Leistungshalbleiterchips mittels Bonddrähte miteinander verbunden. Durch die Verbindung mit Hilfe von Bonddrähten werden die Kosten noch weiter reduziert.

Gemäß einer bevorzugten Ausgestaltung der Erfindung erstreckt sich die isolierende Seitenwandung zwischen einer Bodenplatte und einer Deckelplatte, wobei die Bodenplatte und/oder die Deckelplatte als Kühlplatte ausgestaltet sind. Mit anderen Worten besteht die Bodenplatte oder die Deckelplatte aus einem Material mit hoher Wärmeleitfähigkeit, also beispielsweise einem Metall, wie Aluminium oder dergleichen.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleich wirkende Bauteile verweisen und wobei
- Figur 1: ein Ausführungsbeispiel des erfindungsgemäßen Leistungshalbleitermoduls und
- Figur 2: das Leistungshalbleitermodul gemäß Figur 1 bei der Montage zeigen.

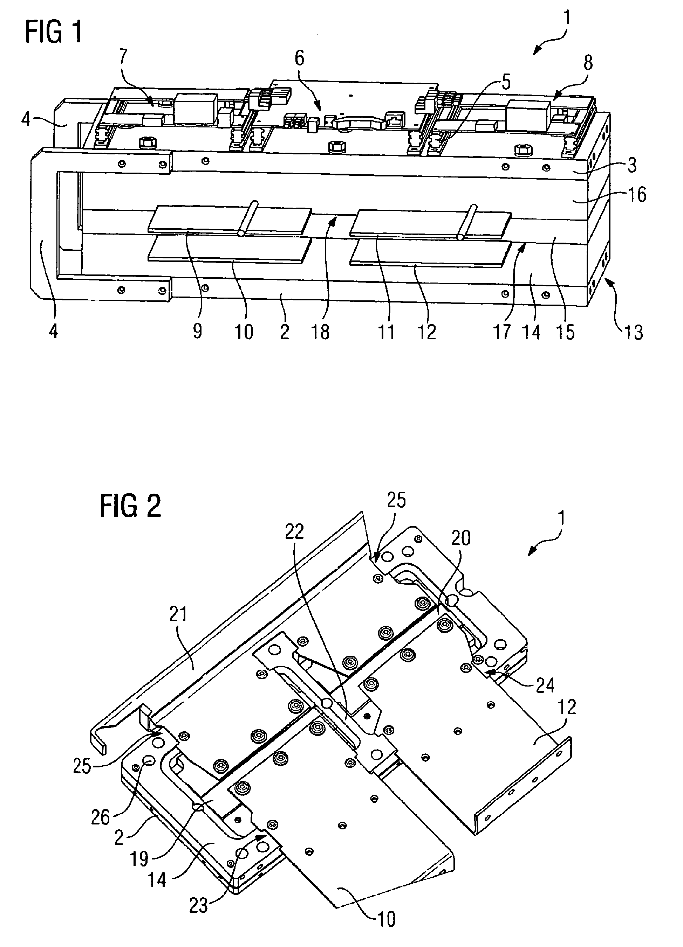

Figur 1 zeigt ein Ausführungsbeispiel des erfindungsgemäßen Leistungshalbleitermoduls in einer perspektivischen Ansicht. Das Leistungshalbleitermodul 1 verfügt über eine untere Bodenplatte 2 sowie eine obere Deckelplatte 3, die jeweils aus einem metallischen Material, hier Aluminium, gefertigt sind. Die Bodenplatte 2 sowie die Deckelplatte 3 stehen in wärmeleitender Verbindung mit in Figur 1 nicht sichtbaren Leistungshalbleitereinheiten, so dass diese aufgrund der hohen Wärmeleitfähigkeit als Kühlplatten wirken. Um die Kühlleistung der Kühlplatten 2, 3 zu verbessern, stehen diese über U-förmige Wärmebrücken 4 miteinander in wärmeleitender Verbindung.

Auf der Deckelplatte 3 sind Kunststoffträger 5 vorgesehen, auf denen wiederum Steuereinheiten 6, 7, 8 angeordnet sind. Die Steuereinheiten 6, 7, 8 stellen für die im Inneren des Leistungshalbleitermoduls 1 angeordneten Leistungshalbleitereinheiten Steuersignale bereit, so dass diese gezielt von einer Sperrstellung, in der ein Stromfluss über die angesteuerte Leistungshalbleitereinheit unterbrochen ist, in eine Leiterstellung, in der ein Stromfluss über die jeweilige Leistungshalbleitereinheit ermöglicht ist, überführt werden können. In der Leiterstellung fließt der Strom von einer Anode der jeweiligen Leistungshalbleitereinheit zu deren Katode.

Im Falle von abschaltbaren Leistungshalbleitereinheiten, wie IBGTs, GTOs oder dergleichen, können diese mit Hilfe des Steuersignals auch von der Leiterstellung in die Sperrstellung überführt werden. Im Falle von Leistungshalbleitereinheiten mit abschaltbaren Leistungshalbleitern weisen die Leistungshalbleitereinheiten jeweils eine Freilaufdiode auf, die dem jeweiligen abschaltbaren Leistungshalbleiter gegensinnig parallel geschaltet ist.

Die Leistungshalbleitereinheiten des Leistungshalbleitermoduls 1 sind über ihre Anode und/oder Katode im Rahmen der Erfindung beliebig miteinander und mit Anschlussschienen 9, 10, 11 und 12 verbunden. Dabei können die Leistungshalbleitereinheiten des Leistungshalbleitermoduls 1 beispielsweise so gesteuert werden, dass ein Stromfluss zwischen den nach außen geführten Anschlussschienen 9 und 10 ermöglicht oder unterbrochen ist.

Zwischen der Bodenplatte 2 und der Deckelplatte 3 erstreckt sich eine Seitenwandung 13, die aus einem elektrisch isolierenden Material, beispielsweise einem glasfaserverstärkten Kunststoff, besteht. Die Bodenplatte 2, die Deckelplatte 3 und die Seitenwandung 13 bilden somit ein Modulgehäuse aus, das im Explosionsfall der Leistungshalbleitereinheiten eine Schutzwirkung für die restlichen Leistungshalbleitermodule und/oder für Bedienpersonal entfaltet.

Die Seitenwandung 13 ist im Rahmen der Erfindung nicht einstückig ausgebildet, sondern schichtweise aufgebaut. Sie besteht aus mehreren aufeinander gestapelten Teilelementen 14, 15 und 16, die mit Kontaktbereichen aneinander anliegen, so dass Anstoßfugen 17 und 18 begrenzt sind. Aufgrund des stapelweisen Aufbaus der Seitenwandung 13 ist eine einfache Montage der Seitenwandung 13 ermöglicht, da die Teilelemente 14, 15, 16 und die Anschlussschienen 9, 10, 11 und 12, welche die Seitenwandung 13 durchgreifen, in beliebiger Reihenfolge montiert werden können.

Figur 2 zeigt das Leistungshalbleitermodul 1 in einer Momentaufnahme während der Montage. Es ist erkennbar, dass das Teilelement 14 und zwei Leistungshalbleitereinheiten 19, 20 mit der Bodenplatte 2 verbunden sind. Weiterhin ist eine winkelige Gleichspannungsanschlussschiene 21 erkennbar, die ebenfalls mit den Leistungshalbleitereinheiten 19, 20 verbunden ist. Zwei weitere in Figur 2 nicht sichtbare Leistungshalbleitereinheiten sind an der Deckelplatte 3 montiert, wobei zur Kontaktierung der Leistungshalbleitereinheiten 19, 20 von außen die Anschlussschienen 9, 10, 11, 12 und 21 vorgesehen sind. Insgesamt verfügt das Leistungshalbleitermodul 1 über vier Leistungshalbleitereinheiten 19, 20, die in dem gezeigten Ausführungsbeispiel als Vollbrücke oder mit anderen Worten H-Brücke miteinander sowie mit einem in Figur 2 nicht dargestellten Kondensator verschaltet sind. Durch entsprechende Ansteuerung der Leistungshalbleitereinheiten kann daher die an dem Kondensator abfallende Spannung U_{c}, eine Nullspannung oder die inverse Kondensatorspannung -U_{c} an den zweipoligen Ausgang der jeweiligen Leistungshalbleitereinheit geschaltet werden.

In Figur 2 ist ferner erkennbar, dass das Teilelement 14 umfänglich geschlossen, also ringförmig, ausgebildet ist, wobei sich zwischen zwei aneinander gegenüberliegen Seiten eine Verstärkungsrippe 22 erstreckt. Zwischen der Verstärkungsrippe 22 und den Außenwandungen des Teilelements 14 sind zwei Hohlräume ausgebildet, in denen jeweils eine Leistungshalbleitereinheit 19 beziehungsweise 20 angeordnet ist. Ferner ist erkennbar, dass das Teilelement 14 Aussparungen 23, 24 und 25 aufweist, die formkomplementär zu der jeweiligen Anschlussschiene 10, 12 beziehungsweise 21 ausgestaltet sind. Aufgrund dieser formkomplementären Ausgestaltung ist der Austritt von Heißgasen, die im Explosionsfall im Inneren des Leistungshalbleitermoduls 1 entstehen, zumindest erschwert.

Zur mechanischen Verspannung der Deckelplatte 3 mit der Bodenplatte 2 und somit der Teilelemente 14, 15, 16 weist, wie in Figur 2 gezeigt ist, jedes Teilelement 14, 15, 16 mehrere Befestigungsbohrungen 26 auf, durch die sich im montierten Zustand des Leistungshalbleitermoduls 1 mit Gewinde versehene Befestigungsbolzen erstrecken. Durch Verschrauben der Befestigungsbolzen mit der Deckelplatte 3 und der Bodenplatte 2 ist ein Leistungshalbleitermodul 1 bereitgestellt, das kostengünstig und explosionsfest ist.

## Patentansprüche

1. Leistungshalbleitermodul (1) mit wenigstens zwei miteinander verschalteten Leistungshalbleitereinheiten (19,20), die ansteuerbare Leistungshalbleiter aufweisen, einem Modulgehäuse (2,3,13), in dem die Leistungshalbleitereinheiten (19,20) angeordnet sind und das eine elektrisch isolierende Seitenwandung (13) aufweist, und wenigstens einer Anschlussschiene (9,10,11,12,21), die sich durch die Seitenwandung (13) hindurch erstreckt und mit wenigsten einer der Leistungshalbleitereinheiten (19,20) verbunden ist,
**dadurch gekennzeichnet, dass**
die isolierende Seitenwandung (13) als Stapel isolierender und einstückig ausgebildeter Teilelemente (14,15,16) ausgebildet ist, wobei die Teilelemente (14) mit Kontaktbereichen aneinander anliegen.

2. Leistungshalbleitermodul (1) nach Anspruch 1,
**dadurch gekennzeichnet, dass**
die Teilelemente (14,15,16) umfänglich geschlossen ausgebildet sind.

3. Leistungshalbleitermodul (1) nach einem der vorhergehenden Ansprüche,
**dadurch gekennzeichnet, dass**
die Teilelemente (14,15,16) wenigstens eine Verstärkungsrippe (22) aufweisen.

4. Leistungshalbleitermodul (1) nach einem der vorhergehenden Ansprüche,
**dadurch gekennzeichnet, dass**
wenigstens eine der Anschlussschienen (9,10,11,12,21) die Seitenwandung (13) zwischen zwei Teilelementen (14,15,16) durchragt.

5. Leistungshalbleitermodul (1) nach einem der vorhergehenden Ansprüche,
**dadurch gekennzeichnet, dass**
wenigstens eines der Teilelemente (14,15,16) in seinem Kontaktbereich eine Aussparung (23,24,25) aufweist, durch die hindurch sich eine der Anschlussschienen (9,10,11,12,21) erstreckt.

6. Leistungshalbleitermodul (1) nach Anspruch 5,
**dadurch gekennzeichnet, dass**
die Aussparung (23,24,25) und die sich durch diese hindurch erstreckende Anschlussschiene (9,10,11,12,21) formkomplementär zueinander ausgebildet sind.

7. Leistungshalbleitermodul (1) nach einem der vorhergehenden Ansprüche,
**dadurch gekennzeichnet, dass**
die Teilelemente (14,15,16) aus einem faserverstärkten Kunststoff bestehen.

8. Leistungshalbleitermodul (1) nach einem der vorhergehenden Ansprüche,
**dadurch gekennzeichnet, dass**
jede Leistungshalbleitereinheit (19,20) Leistungshalbleiterchips und ein Einheitengehäuse aufweisen, in dem die Leistungshalbleiterchips angeordnet sind.

9. Leistungshalbleitermodul (1) nach Anspruch 8,
**dadurch gekennzeichnet, dass**
Leistungshalbleiterchips mittels Bonddrähte miteinander verbunden sind.

10. Leistungshalbleitermodul (1) nach einem der vorhergehenden Ansprüche,
**dadurch gekennzeichnet, dass**
die isolierende Seitenwandung (13) sich zwischen einer Bodenplatte (2) und einer Deckelplatte (3) erstreckt, wobei die die Bodenplatte (2) und/oder die Deckelplatte (3) als Kühlplatte ausgestaltet sind.

## Claims

1. Power semiconductor module (1) having at least two interconnected power semiconductor units (19, 20) comprising switchable power semiconductors, a module housing (2, 3, 13) in which the power semiconductor units (19, 20) are disposed and which has an electrically insulating side wall (13), and at least one connecting bar (9, 10, 11, 12, 21) which extends through the side wall (13) and is connected to at least one of the power semiconductor units (19, 20), **characterized in that** the insulating side wall (13) is constructed as a stack of insulating partial elements (14, 15, 16) designed as a single piece, wherein contact areas of the partial elements (14) rest against one another.

2. Power semiconductor module (1) according to Claim 1, **characterized in that** the partial elements (14, 15, 16) are designed to be circumferentially closed.

3. Power semiconductor module (1) according to one of the preceding claims, **characterized in that** the partial elements (14, 15, 16) have at least one reinforcing rib (22).

4. Power semiconductor module (1) according to one of the preceding claims, **characterized in that** at least one of the connecting bars (9, 10, 11, 12, 21) extends through the side wall (13) between two partial elements (14, 15, 16).

5. Power semiconductor module (1) according to one of the preceding claims, **characterized in that** at least one of the partial elements (14, 15, 16) has a cutout (23, 24, 25) in its contact area, through which one of the connecting bars (9, 10, 11, 12, 21) extends.

6. Power semiconductor module (1) according to Claim 5, **characterized in that** the cutout (23, 24, 25) and the connecting bar (9, 10, 11, 12, 21) which extends through it are designed with a complementary shape to one another.

7. Power semiconductor module (1) according to one of the preceding claims, **characterized in that** the partial elements (14, 15, 16) are made of a fiber-reinforced plastic.

8. Power semiconductor module (1) according to one of the preceding claims, **characterized in that** each power semiconductor unit (19, 20) has power semiconductor chips and a unit housing in which the power semiconductor chips are disposed.

9. Power semiconductor module (1) according to Claim 8, **characterized in that** power semiconductor chips are connected to one another by means of bonding wires.

10. Power semiconductor module (1) according to one of the preceding claims, **characterized in that** the insulating side wall (13) extends between a base plate (2) and a cover plate (3), wherein the base plate (2) and/or the cover plate (3) are designed as a cooling plate.

## Revendications

1. Module ( 1 ) à semiconducteurs de puissance ayant au moins deux unités ( 19, 20 ) à semiconducteurs de puissance, qui sont câblées entre elles et qui ont des semiconducteurs de puissance pouvant être commandés, un boîtier ( 2, 3, 11 ) de module, dans lequel sont placées les unités ( 19, 20 ) à semiconducteurs de puissance et qui a une paroi ( 13 ) latérale isolante du point de vue électrique, et au moins une barre ( 9, 10, 11, 12, 21 ) de connexion, qui traverse la paroi ( 13 ) latérale et qui est reliée à au moins une des unités ( 19, 20 ) à semiconducteurs de puissance,
**caractérisé en ce que**
la paroi ( 13 ) latérale isolante est sous la forme d'une pile d'éléments ( 14, 15, 16 ) partiels isolants et d'une seule pièce, les éléments ( 14 ) partiels s'appliquant l'un à l'autre par des zones de contact.

2. Module ( 1 ) à semiconducteurs de puissance suivant la revendication 1,
**caractérisé en ce que**
les éléments ( 14, 15, 16 ) partiels sont constitués de manière fermée sur le pourtour.

3. Module ( 1 ) à semiconducteurs de puissance suivant l'une des revendications précédentes,
**caractérisé en ce que**
les éléments ( 14, 15, 16 ) partiels ont au moins une nervure ( 22 ) de renfort.

4. Module ( 1 ) à semiconducteurs de puissance suivant l'une des revendications précédentes,
**caractérisé en ce que**
au moins l'une des barres ( 9, 10, 11, 12, 21 ) de connexion traverse la paroi ( 13 ) latérale entre deux éléments ( 14, 15, 16 ) partiels.

5. Module ( 1 ) à semiconducteurs de puissance suivant l'une des revendications précédentes,
**caractérisé en ce que**
au moins l'un des éléments ( 14, 15, 16 ) partiels a dans sa zone de contact un évidement ( 23, 24, 25 ) que traverse l'une des barres ( 9, 10, 11, 12, 21 ) de connexion.

6. Module ( 1 ) à semiconducteurs de puissance suivant la revendication 5,
**caractérisé en ce que**
l'évidement ( 23, 24, 25 ) et la barre ( 9, 10, 11, 12, 21 ) qui le traverse sont à complémentarité de forme l'un de l'autre.

7. Module ( 1 ) à semiconducteurs de puissance suivant l'une des revendications précédentes,
**caractérisé en ce que**
les éléments ( 14, 15, 16 ) partiels sont en une matière plastique renforcée par de la fibre.

8. Module ( 1 ) à semiconducteurs de puissance suivant l'une des revendications précédentes,
**caractérisé en ce que**
chaque unité ( 19, 20 ) à semiconducteurs de puissance a des puces à semiconducteurs de puissance et un boîtier d'unité, dans lequel les puces à semiconducteurs de puissance sont placées.

9. Module ( 1 ) à semiconducteurs de puissance suivant la revendication 8,
**caractérisé en ce que**
des puces à semiconducteurs de puissance sont reliées entre elles au moyen de fils de liaison.

10. Module ( 1 ) à semiconducteurs de puissance suivant l'une des revendications précédentes,
**caractérisé en ce que**
la paroi ( 13 ) latérale isolante s'étend entre une plaque ( 2 ) de fond et une plaque ( 3 ) de couvercle, la plaque ( 2 ) de fond et/ou la plaque ( 3 ) de couvercle étant conformée en plaque de refroidissement.
